# EUROPÄISCHE PATENTANMELDUNG

(11) **EP 1 453 369 A2**
(43) Veröffentlichungstag der Anmeldung: **01.09.2004**
(21) Anmeldenummer: 04001105.8
(22) Anmeldetag: 20.01.2004
(51) Int. Cl.: H05K 9/00

(54) **Gerätegehäuse**

(30) Priorität: 28.02.2003 DE 10308868
(71) Anmelder: Fujitsu Siemens Computers GmbH, 80807 München (DE)
(72) Erfinder: Hesse, Ronny, 33189 Schlangen (DE); Fietz, Ralf-Peter, 33104 Paderborn (DE)
(74) Vertreter: Epping Hermann & Fischer

(57) **Zusammenfassung**

Die Erfindung betrifft ein Gerätegehäuse (2) mit einem Deckel (1) und einer Verriegelungsvorrichtung zum Festlegen des Deckels (1) an dem Gerätegehäuse (2), wobei der Deckel (1) oder das Gerätegehäuse (2) einen Drehknopf (3) mit einem Sperrelement (16) aufweisen, wobei durch einen mit dem Drehknopf (3) verbundenen Hebel, welcher zwei in einem definierten Winkel miteinander starr verbundene Schenkel (8,9) aufweist und an der Schnittstelle der beiden Schenkel (8,9) an dem Deckel (1) oder dem Gerätegehäuse (2) drehbar befestigt ist, der Deckel (1) am Gerätegehäuse (2) festlegbar ist.

## Beschreibung

Die Erfindung betrifft ein Gerätegehäuse mit einem Deckel und einer Verriegelungsvorrichtung zum Festlegen des Deckels an dem Gerätegehäuse.

Gerätegehäuse müssen vielen unterschiedlichen Anforderungen gerecht werden. Bei Computern und Servern ist es wichtig einen schnellen und komfortablen Zugriff auf die elektronischen Bauteile zu haben, ohne auf die Abschirmung störender elektromagnetischer Strahlung und auf den Schutz vor ungewolltem Zugriff auf die Hardware verzichten zu müssen.

Bei den auf dem Markt befindlichen Gerätegehäusen variieren die Verschlußmöglichkeiten in Abhängigkeit von dem speziellen Einsatz stark. Sehr komfortable Verschlußsysteme gibt es vor allem bei PC's, da hier in der Regel die Deckel häufig entfernt werden.

Im Serverbereich gibt es einige verschließbare Gehäuse, die nur mit einem Schlüssel oder entsprechendem Werkzeug geöffnet werden können. Hier kommt jedoch der Komfort und eine schnelle Handhabung zu kurz.

Um die EMV-Abschirmung von Gerätegehäusen zu gewährleisten bieten viele Hersteller EMV-Dichtungen an, die sich zwischen Deckel und Gehäuse befinden. Beim Schließen des Deckel werden die EMV-Dichtungen zusammengepreßt und dichten so das Gerätegehäuse ab. Der Nachteil hierbei ist, daß in der Regel Muskelkraft aufgewendet werden muß, um gegen den Widerstand der EMV-Dichtungen anzukommen. Das führt zu Einbußen im Komfort.

Einige Hersteller haben daher Verschlußsysteme entwickelt, bei denen der Vorgang des Öffnens bzw. des Schließens mechanisch unterstützt wird. Jedoch weisen diese Verschlüsse keine Sicherheitsverschlüsse auf, um den Zugriff auf die Hardware von nicht autorisierten Personen zu verhindern.

Aus der Druckschrift DE 195 37 684 A1 geht eine Verriegelungsvorrichtung hervor, bei der in einen Drehknopf in dem exzentrische Ausnehmungen vorgesehen sind, stiftartige Erhehbungen in besagte Ausnehmungen

Der Erfindung liegt daher die Aufgabe zugrunde ein Gerätegehäuse aufzuzeigen, welches eine im Deckel oder im Gerätegehäuse integrierte, komfortabel bedienbare Verriegelungsvorrichtung aufweist, durch welche die Öffnungs- und Schließbewegung des Deckels mittels eines Hebels mechanisch unterstützt wird und welche zusätzlich durch einen Sicherheitsverschluß gesichert ist.

Die Aufgabe wird durch eine Erfindung der Eingangs erwähnten Art dadurch gelöst, daß der Deckel oder das Gerätegehäuse einen Drehknopf mit einem Sperrelement aufweisen, wobei durch einen mit dem Drehknopf verbundenen Hebel, welcher zwei in einem definierten Winkel miteinander starr verbundene Schenkel aufweist und an der Schnittstelle der beiden Schenkel an dem Deckel, oder dem Gerätegehäuse, drehbar befestigt ist, der Deckel am Gerätegehäuse festlegbar ist.

Der Drehknopf und der Hebel können entweder am Gerätegehäuse oder am Deckel befestigt sein. Die Funktionsweise ändert sich dadurch nicht. Im Folgenden wird nur auf die am Deckel befindliche Lösung näher eingegangen.

Die Kombination von einem Drehknopf und einem Hebel, die über eine Schraube miteinander drehbar verbunden sind, ermöglicht in vorteilhafter Weise mit wenig Kraftaufwand einen hohen gut dosierten Druck auf die Berührpunkte zwischen Deckel und Gerätegehäuse auszuüben.

Vorteilhafter Weise weist der Hebel zwei unterschiedlich lange Schenkel auf, deren Längen so ausgelegt sind, daß die Kraft die am Drehknopf anfällt verstärkt wird und daß bei lose aufgelegtem Deckel ein Befestigungselement das an dem, dem Drehknopf abgewandten, Schenkel befestigt ist, in ein entsprechendes Gegenstück am Gerätegehäuse eingreift und beim Drehen des Drehknopfes in Verschlußrichtung den Deckel an das Gerätegehäuse preßt.

Die EMV-Abschirmung wird in einer günstigen Weiterbildung durch EMV-Dichtungen gewährleistet, die zwischen Deckel und Gerätegehäuse angebracht sind und mit Hilfe des Anpreßdrucks von dem Deckel auf das Gehäuse wirken.

Die Sicherheit vor ungewolltem Zugriff auf die Hardware wird bei einer Ausführungsform erhöht, bei welcher der Drehknopf ein Sperrelement aufweist, durch welches er in verriegelter Position festgelegt werden kann und welches nur mit Hilfe eines Werkzeuges entriegelbar ist.

Weitere Einzelheiten und Ausgestaltungen der Erfindung sind in den Unteransprüchen angegeben.

Die Erfindung wird nachfolgend an einem Ausführungsbeispiel anhand der Zeichnungen näher erläutert.

In den Zeichnungen zeigen:
- Figur 1: Außenseite eines Deckels mit Drehknopf,
- Figur 2: Innenseite des Deckels mit Drehknopf und Verriegelungselement,
- Figur 3: Gerätegehäusewand mit Rastmitteln,
- Figur 4: Drehknopf mit Sperrelement in verriegelter Position,
- Figur 5: Drehknopf mit Sperrelement in geöffneter Position.

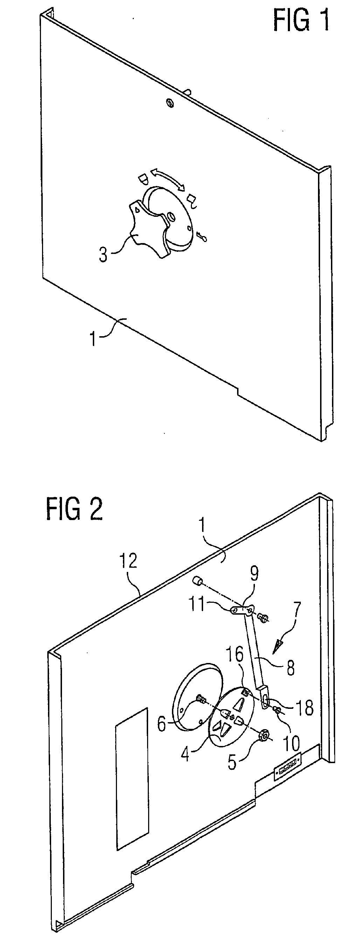

Figur 1 ist eine Explosionsdarstellung der Außenseite eines Deckels 1 für ein Gerätegehäuse 2 mit einem Drehknopf 3, dessen Oberseite in eingesetztem Zustand mit dem Deckel 1 bündig ist.

Figur 2 ist eine Explosionsdarstellung der Unterseite des Deckels 1. Sie zeigt eine Drehscheibe 4 die mit einer Mutter 5 an einer Drehachse 6 der Drehscheibe 4 festgeschraubt ist.

An der Außenseite der Drehscheibe 4 ist ein Hebel 7, mit einem langen Schenkel 8 und einem kurzen Schenkel 9, über eine Schraube 10 und eine Buchse 16 an der Drehscheibe 4 befestigt. Die Schraube 10 ist durch ein Langloch 18 im langen Schenkel 8 gesteckt und in der Buchse 16 an der Drehscheibe 4 festgelegt.

An der dem Drehknopf 3 abgewandten Seite des langen Schenkels 8 ist der kurze Schenkel 9 in einem definierten Winkel befestigt.

An der Schnittstelle der beiden Schenkel 8 und 9 ist der Hebel 7 drehbar an dem Deckel 1 befestigt.

Das dem langen Schenkel 8 abgewandte Ende des kurzen Schenkels 9 weist ein Befestigungsmittel 11 auf.

Durch eine Drehbewegung des Drehknopfes 3 wird der Hebel 7 derart geschwenkt, daß das Befestigungsmittel 11 eine Bewegung ausführt deren Richtung eine Komponente senkrecht zu einer Deckelkante 12 und eine Komponente waagrecht zur Deckelkante 12 aufweist.

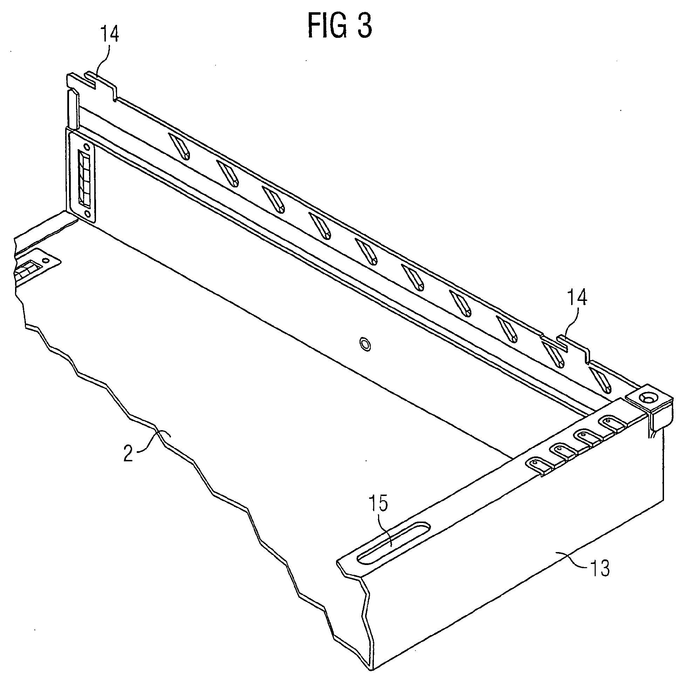

Figur 3 zeigt ein Gerätegehäuse 2 auf das der Deckel 1 beim Schließen aufgelegt wird. Das Gerätegehäuse weist eine Gerätegehäusewandung 13 sowie eine darauf senkrecht stehende Wandung mit zwei Rastmittel 14 auf, die mit entsprechenden Gegenrasten (nicht abgebildet) am Deckel 1 im geschlossenen Zustand zusammenwirken.

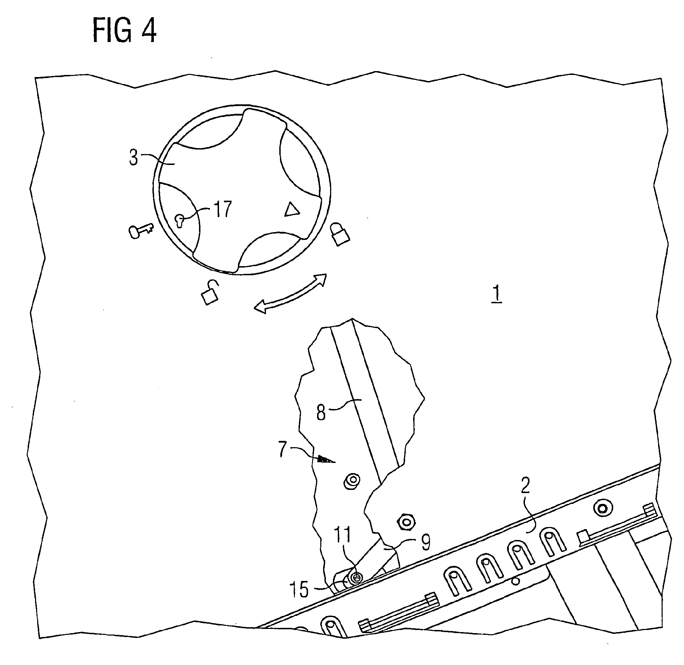

Figur 4 zeigt den auf ein Gerätegehäuse 2 aufgelegten Deckel 1 in verschlossenem Zustand. Ein Schnitt durch einen Teil des Deckels 1 zeigt den Hebel 7 und das Befestigungsmittel 11 das in ein entsprechendes Gegenstück 15 am Gerätegehäuse 2 eingesteckt und verriegelt ist.

Im Drehknopf 3 ist ein Sperrelement integriert, durch welches sich der Drehknopf 3 in geschlossener oder in geöffneter Stellung festlegen läßt. Das Sperrelement läßt sich entriegeln indem ein längliches dünnes Werkzeug, z.B. eine aufgebogene Büroklammer, in eine Öffnung 17 in der Drehscheibe 4 gesteckt wird.

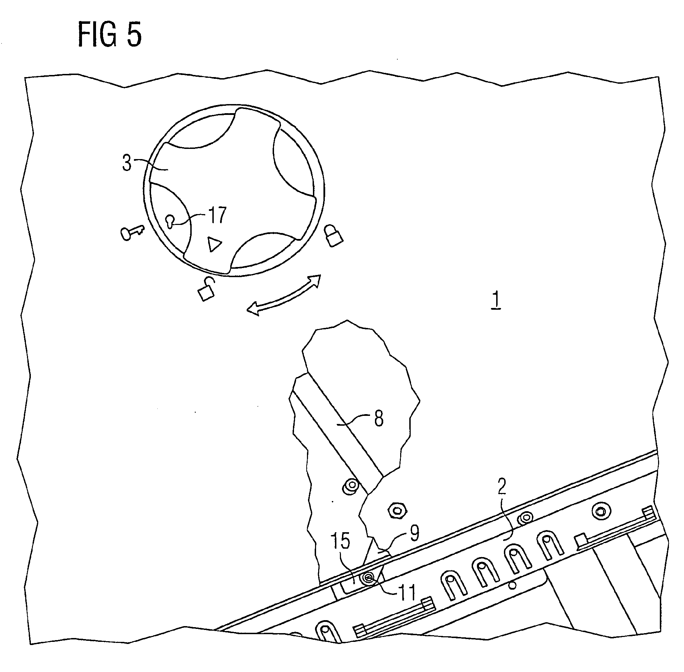

Figur 5 zeigt die selben Bauteile wie Figur 4 mit dem selben Schnitt durch den Deckel 1. Die Position des Drehknopfes 3 und damit auch des Hebels 7 und des Befestigungsmittels 11 entspricht dem geöffneten Zustand.

Wird der Drehknopf 3 in die geschlossene Stellung gedreht, so wirkt eine Hebelkraft auf das Befestigungsmittel 11 in dem Gegenstück 15. Die Kraft die durch das Befestigungsmittel 11 übertragen wird zieht den Deckel 11 in Richtung Gegenstück 15 und somit in die Rastmittel 14.

Die zur Deckelkante 12 parallele Kraftkomponente verschiebt das Befestigungsmittel 11 im Gegenstück 15 hin und her. Die zur Deckelkante 12 senkrechte Kraftkomponente zieht den Deckel 1 zur Gerätegehäusewand 13, preßt ihn an und läßt die Rastmittel 14 (Fig.3) mit den entsprechenden Gegenrasten (nicht dargestellt) zusammenwirken.

Die Erfindung ist nicht auf dieses Ausführungsbeispiel beschränkt. Die gesamte Vorrichtung kann auch am Gerätegehäuse 2 angebracht sein. Außerdem können sich zwischen Deckel 1 und Gerätegehäuse 2 EMV-Dichtungen befinden.

### Bezugszeichenliste:

- 1: Deckel
- 2: Gerätegehäuse
- 3: Drehknopf
- 4: Drehscheibe
- 5: Mutter
- 6: Drehachse
- 7: Hebel
- 8: langer Schenkel
- 9: kurzer Schenkel
- 10: Schraube
- 11: Befestigungsmittel
- 12: Deckelkante
- 13: Gerätegehäusewand
- 14: Rastmittel
- 15: Gegenstück
- 16: Buchse
- 17: Öffnung
- 18: Langloch

## Patentansprüche

1. Gerätegehäuse (2) mit einem Deckel (1) und einer Verriegelungsvorrichtung zum Festlegen des Deckels (1) an dem Gerätegehäuse (2),
**dadurch gekennzeichnet, dass** der Deckel (1) oder das Gerätegehäuse (2) einen Drehknopf (3) aufweist, wobei durch einen mit dem Drehknopf (3) verbundenen Hebel (7), welcher zwei in einem definierten Winkel miteinander starr verbundene Schenkel (8,9) aufweist und an der Schnittstelle der beiden Schenkel (8,9) an dem Deckel (1) oder dem Gerätegehäuse (2) drehbar befestigt ist, eine Kraft zum Verschieben und Verriegeln des Deckels (1) übertragbar ist.

2. Gerätegehäuse (2) nach Anspruch 1
**dadurch gekennzeichnet, dass** der Drehknopf (3) durch ein Sperrelement in der geschlossenen Stellung festgelegt ist.

3. Gerätegehäuse (2) nach Anspruch 1 oder 2,
**dadurch gekennzeichnet, dass** der festgelegte Drehknopf (3) mit einem Werkzeug entriegelbar ist.

4. Gerätegehäuse (2) nach einem der Ansprüche 1 bis 3,
**dadurch gekennzeichnet, dass** die beiden Schenkel (8,9) unterschiedlich lang sind.

5. Gerätegehäuse (2) nach einem der Ansprüche 1 bis 4,
**dadurch gekennzeichnet, dass**
der lange Schenkel (8) an der Seite, die dem kurzen Schenkel (9) gegenüberliegt, ein Langloch (18) aufweist, in das eine am Rand des Drehknopfes (3) befestigte Schraube (10) eingreift.

6. Gerätegehäuse (2) nach einem der Ansprüche 1 bis 5,
**dadurch gekennzeichnet, dass** der kurze Schenkel (9) an der Seite die dem langen Schenkel (8) gegen überliegt, ein Befestigungsmittel (11) aufweist, welches im verriegelten Zustand mit einem entsprechendem Gegenstück (15) am Deckel (1) oder am Gerätegehäuse (2) zusammenwirkt.

7. Gerätegehäuse (2) nach einem der Ansprüche 1 bis 7,
**dadurch gekennzeichnet, dass**
das Gerätegehäuse (2) Rastmittel (14) aufweist, die mit entsprechenden Gegenrasten am Deckel (1) zusammenwirken.

8. Gerätegehäuse (2) nach Anspruch 7,
**dadurch gekennzeichnet, dass**
bei einer ersten Stellung des Drehknopfes (3) der Deckel (1) nicht ganz geschlossen ist und durch Drehen in eine zweite Stellung die Rastmittel (14) am Gerätegehäuse (2) durch das Zusammenwirken von Drehknopf (3), Hebel (7), Befestigungsmittel (11) und Gegenstück (15) in die entsprechenden Gegenrasten am Deckel (1) einrasten und den Deckel (1) in geschlossenem Zustand festlegen.
